# EUROPÄISCHE PATENTSCHRIFT

(11) **EP 2 257 654 B1**
(45) Veröffentlichungstag und Bekanntmachung des Hinweises auf die Patenterteilung: **01.08.2012**
(21) Anmeldenummer: 09728049.9
(22) Anmeldetag: 18.03.2009
(51) Int. Cl.: C23C 16/02, C23C 16/26, F16J 9/26, C23C 28/04

(54) **KOLBENRING**
PISTON RING
SEGMENT DE PISTON

(30) Priorität: 02.04.2008 DE 102008016864
(43) Veröffentlichungstag der Anmeldung: 08.12.2010
(73) Patentinhaber: Federal-Mogul Burscheid GmbH, 51399 Burscheid (DE)
(72) Erfinder: HOPPE, Steffen, 51491 Overath (DE); FISCHER, Manfred, 42799 Leichlingen (DE)
(74) Vertreter: HOFFMANN EITLE
(86) Internationale Anmeldenummer: PCT/EP2009/053192
(87) Internationale Veröffentlichungsnummer: WO 2009/121719

(56) Entgegenhaltungen:
- WO-A1-01/79585
- WO-A1-03/091474
- WO-A1-2006/125683
- WO-A1-2007/020139
- JP-A- 2004 010 923
- US-B1- 6 228 471

## Beschreibung

### Technisches Gebiet

Die Erfindung betrifft einen Kolbenring mit einer neuartigen Beschichtung.

Kolbenringe werden in Verbrennungsmotoren eingesetzt, um zwischen dem sich auf und ab bewegenden Kolben und der Zylinderwand eine möglichst perfekte Abdichtung zu schaffen. Ferner dienen Kolbenringe dazu, das an der Zylinderwand befindliche Öl abzustreifen und die Nutzbarkeit dieses Öls für die Schmierung zu erhalten. Die wesentlichen Anforderungen an Kolbenringe bestehen in einer möglichst geringen Reibung sowie einer möglichst langen Lebensdauer unter den teilweise extremen Anforderungen beim Betrieb eines Verbrennungsmotors. Dies impliziert ein Verschleißverhalten, bei dem der Kolbenring seinen Anforderungen möglichst lange gerecht wird.

### Stand der Technik

Die WO 2007/020139 A1 beschreibt ein Substrat, bei dem es sich um einen Kolbenring handeln kann, mit einer Haftschicht, einer Zwischenschicht aus tetraedischem Kohlenstoff, und einer äußeren Schicht aus amorphem Kohlenstoff.

Aus der DE 10 2005 063 123 B3 der Anmelderin geht ein Gleitelement, beispielsweise ein Kolbenring hervor, der eine Verschleißschicht und eine Einlaufschicht aufweist.

Die WO 2006/125683 A1 betrifft einen Kolbenring mit einer Beschichtung, die, von innen nach außen, eine erste Zwischenschicht mit wenigstens einem Element der Gruppe IVB, VB oder VIB, eine zweite Zwischenschicht mit einer diamantartigen, nanokompositären Zusammensetzung und eine diamantartige Kohlenstoffschicht aufweist.

### Darstellung der Erfindung

Der Erfindung liegt die Aufgabe zugrunde, einen Kolbenring zu schaffen, der mit geringerem Aufwand als die im Stand der Technik bekannten Kolbenringe herstellbar ist und gleichzeitig den Anforderungen im Hinblick auf die Reibungswerte und/oder die Lebensdauer genügt.

Die Lösung dieser Aufgabe erfolgt durch den im Anspruch 1 beschriebenen Kolbenring.

Demzufolge weist dieser von innen nach außen eine auf einem Grundwerkstoff aufgebrachte Haftschicht, eine metallhaltige amorphe Kohlenstoffschicht und eine metallfreie amorphe Kohlenstoffschicht auf. Durch diesen Schichtaufbau kann auf den im Stand der Technik üblichen Aufbau mit einer Einlaufschicht und einer separat ausgebildeten Verschleißschutzschicht verzichtet werden. Die bekannten Verschleißschutzschichten sind zumeist als Nitrierschichten ausgebildet und erfordern die Verwendung von Stählen mit hohen Chromanteilen, die vergleichsweise kostspielig sind. Demgegenüber sind gemäß der Erfindung keine hohen Anteile an Chrom erforderlich, so dass der neuartige Kolbenring kostengünstig herstellbar ist. Insoweit kann der Grundgedanke der Erfindung auch darin gesehen werden, dass die neuartige Kohlenstoffbeschichtung auf dem Substrat ohne Dazwischenschaltung einer eigenen Verschleißschutzschicht, lediglich mit einer dünnen Haftschicht zur Haftvermittlung zwischen dem Substrat und der Kohlenstoffschicht, versehen ist.

Für den erfindungsgemäßen Kolbenring zeigt sich anhand von Tests, wie nachfolgend detailliert ausgeführt, dass die Reibungskoeffizienten dauerhaft niedrig sind. In dieser Hinsicht bietet der neuartige Kolbenring dementsprechend eine lange Lebensdauer. Dies gilt in gleicher Weise im Hinblick auf den Verschleiß, für den festgestellt wurde, dass er sich in Grenzen bewegt, die eine lange Lebensdauer garantieren. Die metallhaltige amorphe Kohlenstoffschicht kann gemäß den üblichen Bezeichnungen (vgl. VDI-Richtlinie 2840) mit der Abkürzung a-C:H:Me bezeichnet werden. Die entsprechende Bezeichnung für die metallfreie amorphe Kohlenstoffschicht ist a-C:H. Die metallfreie Kohlenstoffschicht kann beispielsweise im Rahmen eines eigenen Prozessschrittes innerhalb eines PACVD (plasma assisted chemical vapor deposition)-Verfahrens aufgebracht werden. Bei beiden amorphen Kohlenstoffschichten handelt es sich um DLC (diamond-like carbon)-Schichten.

In der metallhaltigen Kohlenstoffschicht liegen überwiegend sp²-Bindungen vor. Mit dieser Eigenschaft konnten bei dem erfindungsgemäßen Kolbenring die für den Kolbenring gewünschten Eigenschaften festgestellt werden. Im Besonderen liegen die Anteile im Bereich von 20% bis 70% des Gesamtanteiles der Kohlenstoffbindungen.

Im Hinblick auf die metallfreie Kohlenstoffschicht gilt, dass der sp³-Bindungsanteil höher ist als der sp³-Bindungsanteil der metallhaltigen Kohlenstoffschicht. Ein bevorzugter Bindungsanteil an sp³-Anteilen ist dann gegeben, wenn sich ein erhöhter elektrischer Widerstand (Ohm) einstellt. Während übliche DLC-Beschichtungen einen elektrischen Widerstand im Bereich kleiner 100 Ohm aufweisen, liegt der bevorzugte erhöhte elektrische Widerstand der erfindungsgemäßen Schicht über 5000 Ohm, insbesondere über 5000 kOhm und bevorzugt bei weniger als 10 kOhm.

Für den Grundwerkstoff des erfindungsgemäßen Kolbenrings ist Stahl oder Eisenguss vorgesehen.

Die Haftschicht enthält Chrom und kann insbesondere überwiegend aus Chrom bestehen. Für eine derartige Haftschicht wurde festgestellt, dass sie die gewünschten Haft vermittelnden Eigenschaften zwischen dem Grundwerkstoff und der metallhaltigen amorphen Kohlenstoffschicht aufweist.

Aufgrund von Versuchsergebnissen wird für die Haftschicht derzeit eine Dicke von maximal 2 µm, bevorzugt etwa 0,5 µm vorgesehen.

Erfindungsgemäß nimmt der Metallanteil innerhalb der metallhaltigen Kohlenstoffschicht zur Außenseite hin ab.

Im Hinblick auf die Dicke wird für die metallhaltige Kohlenstoffschicht eine Dicke von etwa 1,5 bis etwa 17 µm vorgesehen. Insbesondere konnte bei einer Schichtdicke von etwa 1,5 µm ein gutes Verhalten festgestellt werden. Besonders gute Eigenschaften konnten ferner festgestellt werden, weil die in der metallhaltigen Kohlenstoffschicht nanokristalline Carbidphasen enthält.

Die metallhaltige und die metallfreie Kohlenstoffschicht enthalten ferner Wasserstoff. Der vorhandene Wasserstoff hat einen Einfluss auf den Vernetzungsgrad des Kohlenstoffs und führt dadurch zu besonders harten Schichten.

Die Oberflächenhärte des erfindungsgemäß gestalteten Kolbenrings beträgt 1800 bis 2800 HV, bevorzugt bis 2400 HV 0,002. Die Messung erfolgt hierbei mit einem Nanoindenter mit HV pl 0,002. Die Abkürzung pl steht für plastisch, und das entsprechende Verfahren ist den Fachleuten geläufig. In besonderen Anwendungsfällen ist auch eine Messung mit einem Nanoindenter mit HV pl 0,02 möglich.

Bevorzugte Weiterbildungen sind in den weiteren Ansprüchen beschrieben.

Für die metallhaltige Kohlenstoffschicht wird im Hinblick auf das darin enthaltene Metall derzeit bevorzugt, dass es sich um Wolfram handelt. Hierfür konnten bei Tests besonders gute Eigenschaften festgestellt werden.

Für die metallfreie Kohlenstoffschicht wurden ferner gute Eigenschaften des damit versehenen Kolbenrings festgestellt, wenn diese eine Dicke von etwa 1 µm bis etwa 15 µm, insbesondere etwa 1 µm aufweist.

Für die Gesamtdicke der auf den Grundwerkstoff aufgebrachten Schichten wird derzeit bevorzugt, dass diese ≥ etwa 2,9 µm und vorzugsweise ≤ etwa 30 µm ist. Dies stellt in vorteilhafter Weise einen Unterschied zu den bislang bekannten DLC-Schichten dar, die zumeist dünner sind. Durch die erfindungsgemäß realisierbaren Dicken lässt sich der Vorteil realisieren, auf eine eigene Verschleißschutzschicht verzichten zu können, da die DLC-Schichten sowohl als Einlauf- als auch als Verschleißschutzschicht wirken.

Für die Haftschicht, die bevorzugt aus Chrom besteht, wird derzeit bevorzugt, dass sie metallisch aufgedampft wird.

Im Hinblick auf die metallhaltige und/oder die metallfreie Kohlenstoffschicht wird derzeit bevorzugt, dass sie mittels eines PACVD (plasma assisted chemical vapor deposition) -Verfahrens aufgebracht wird.

Im Übrigen sei im Hinblick auf sämtliche Merkmale des erfindungsgemäßen Kolbenrings, die darauf vorgesehene Beschichtung sowie den damit bevorzugt zusammen wirkenden Gleitpartnern auf die eingangs erwähnte DE 10 2005 063 123 B3 oder die hierauf zurückgehende WO 2007/079834 A1 verwiesen, deren Offenbarung im Hinblick auf die genannten Merkmale zum Gegenstand der vorliegenden Anmeldung gemacht wird.

### Beispiele

Es wurde ein erfindungsgemäßer Kolbenring mit einer Beschichtung mit einer Dicke von insgesamt etwa 2,9 µm hergestellt, für den eine Härte von 1935 HV 0,002 ermittelt wurde. Dieser Kolbenring wurde zusammen mit einem Kolbenring mit einer Nitrierschicht als Verschleißschutzschicht und einem in Serie hergestellten DLC-beschichteten Kolbenring einem Verschleißtest unterzogen. Dieser erfolgte bei 190° C, 50 N Belastung und unter Verwendung von Castrol VP1 als Öl. Als Bohrung wurde Silitec S260 verwendet. Das entsprechende Produkt ist den Fachleuten bekannt. Nach sechs Stunden wurde an dem erfindungsgemäßen Kolbenring ein Verschleiß von etwa 1,0 µm, bei dem serienmäßigen DLC-beschichteten Kolbenring ein Verschleiß von etwa 5,3 µm festgestellt. Üblicherweise erhöht sich bei einer verschleißfesteren Beschichtung der Verschleiß des Gleitpartners. Die erfindungsgemäße Beschichtung zeigt überraschenderweise keinen höheren Verschleiß an dem Gleitpartner wie der Zylinderlaufbuchse des Zylinders.

Der Verschleiß der Zylinderbuchse betrug bei dem erfindungsgemäßen Kolbenring 2,7 µm, bei dem serienmäßigen DLC-beschichteten Kolbenring 2,8 µm. Darüber hinaus ergab sich für den erfindungsgemäßen Kolbenring eine deutliche Senkung des Reibkoeffizienten. Gegenüber eines üblichen DLC-beschichteten Kolbenrings ergab sich eine Absenkung des Reibungskoeffizienten um bis zu 30 %.

Es wurde somit gezeigt, dass für den erfindungsgemäßen Kolbenring vorteilhafte Eigenschaften erreicht werden. Dies gilt, wie ausgeführt, insbesondere für den Reibungskoeffizienten, vor allem längerfristig betrachtet, das Einlaufverhalten und die Scuff-Resistenz, was insgesamt zu einem langlebigen Kolbenring führt.

## Patentansprüche

1. Kolbenring mit einer DLC-Beschichtung, der von innen nach außen auf Eisenguss oder Stahl als einem Grundwerkstoff eine Haftschicht mit Chrom und einer Dicke von maximal etwa 2 µm, eine metall- und wasserstoffhaltige amorphe Kohlenstoffschicht, die eine Dicke von etwa 1,5 µm bis 17 µm aufweist und nanokristalline Carbidphasen enthält, und bei welcher der Metallanteil in Richtung der Außenseite abnimmt, und eine metallfreie und wasserstoffhaltige amorphe Kohlenstoffschicht aufweist, wobei in der metallhaltigen Kohlenstoffschicht überwiegend sp²-Bindungen vorliegen, und die metallfreie Kohlenstoffschicht sp²- und sp³-Bindungen aufweist, und der sp³-Bindungsanteil höher ist als in der metallhaltigen Kohlenstoffschicht, wobei die Beschichtung eine Oberflächenhärte von 1800 bis 2800 HV 0,002 aufweist, sich ein elektrischer Widerstand der DLC-Beschichtung einstellt, der im Bereich größer 5000 kOhm liegt, und auf der Beschichtung keine Einlaufschicht vorgesehen ist.

2. Kolbenring nach Anspruch 1,
**dadurch gekennzeichnet, dass** die metallhaltige Kohlenstoffschicht Wolfram enthält.

3. Kolbenring nach Anspruch 1 oder 2,
**dadurch gekennzeichnet, dass** die metallfreie Kohlenstoffschicht eine Dicke von etwa 1 bis etwa 15 µm aufweist.

4. Kolbenring nach einem der vorangehenden Ansprüche,
**dadurch gekennzeichnet, dass** die Schichten insgesamt eine Dicke von ≥ etwa 2,9 µm, vorzugsweise ≤ 30 µm aufweist.

5. Kolbenring nach einem der vorangehenden Ansprüche,
**dadurch gekennzeichnet, dass** die Haftschicht metallisch aufgedampft ist.

6. Kolbenring nach einem der vorangehenden Ansprüche,
**dadurch gekennzeichnet, dass** die metallhaltige und/oder die metallfreie Kohlenstoffschicht mittels eines PACVD-Verfahrens aufgebracht ist.

## Claims

1. Piston ring having a DLC coating, which has from inside to out on cast iron or steel as a base material, an adhesive layer with chromium and a thickness of at the most about 2 µm, a metal-containing and hydrogen-containing amorphous carbon layer which has a thickness of about 1.5 µm to 17 µm and contains nanocrystalline carbide phases, and in which the metal proportion decreases in the direction of the outer side, and a metal-free and hydrogen-containing amorphous carbon layer, wherein predominantly sp² bonds are present in the metal-containing carbon layer, and the metal-free carbon layer has sp² bonds and sp³ bonds, and the sp³ bond proportion is higher than in the metal-containing carbon layer, wherein the coating has a surface hardness of 1,800 to 2,800 HV 0.002, an electrical resistance of the DLC coating being set which lies in the range greater than 5,000 kOhm, and no feed layer is provided on the coating.

2. Piston ring according to claim 1, **characterised in that** the metal-containing carbon layer contains tungsten.

3. Piston ring according to claim 1 or 2, **characterised in that** the metal-free carbon layer has a thickness of about 1 to about 15 µm.

4. Piston ring according to one of the preceding claims, **characterised in that** the layers altogether have a thickness of ≥ about 2.9 µm, preferably ≤ 30 µm.

5. Piston ring according to one of the preceding claims, **characterised in that** the adhesive layer is applied by metal vapour deposition.

6. Piston ring according to one of the preceding claims, **characterised in that** the metal-containing and/or the metal-free carbon layer is applied by means of a PACVD method.

## Revendications

1. Segment de piston pourvu d'un revêtement DLC, lequel comporte, de l'intérieur vers l'extérieur sur de la fonte de fer ou de l'acier comme matériau de base, une couche d'adhérence avec du chrome et présentant une épaisseur de 2 µm environ au maximum, une couche carbone amorphe à teneur en métal et en hydrogène présentant une épaisseur comprise entre environ 1,5 µm et 17 µm et contenant des phases carbure nanocristallines, et pour laquelle la part métallique décroît en direction de l'extérieur, et une couche carbone amorphe exempte de métal et à teneur en hydrogène, des liaisons sp² étant majoritairement présentes dans la couche carbone à teneur en métal, la couche carbone exempte de métal comportant des liaisons sp² et sp³, et la part de liaisons sp³ étant supérieure à celle dans la couche carbone à teneur en métal, le revêtement présentant une dureté de surface comprise entre 1800 et 2400 HV 0,002, une résistance électrique du revêtement DLC étant présentée, laquelle est située dans la plage supérieure à 5000 kOhm, et aucune couche de rodage n'étant prévue sur le revêtement.

2. Segment de piston selon la revendication 1, **caractérisé en ce que** la couche carbone à teneur en métal contient du tungstène.

3. Segment de piston selon la revendication 1 ou la revendication 2, **caractérisé en ce que** la couche carbone exempte de métal présente une épaisseur comprise entre 1 µm environ et 15 µm environ.

4. Segment de piston selon l'une des revendications précédentes, **caractérisé en ce que** les couches présentent globalement une épaisseur supérieure ou égale à 2,9 µm environ, et de préférence inférieure ou égale à 30 µm environ.

5. Segment de piston selon l'une des revendications précédentes, **caractérisé en ce que** la couche d'adhérence est métallisée par vaporisation.

6. Segment de piston selon l'une des revendications précédentes, **caractérisé en ce que** la couche carbone à teneur en métal et/ou la couche carbone exempte de métal sont appliquées au moyen d'un procédé PACVD.
